# EUROPEAN PATENT SPECIFICATION

(11) **EP 2 129 194 B1**
(45) Date of publication and mention of the grant of the patent: **07.08.2013**
(21) Application number: 08251832.5
(22) Date of filing: 27.05.2008
(51) Int. Cl.: H05K 1/02, H05K 1/14, G06F 1/18, G06F 13/40

(54) **Electronic apparatus**
Elektronische Vorrichtung
Appareil électronique

(43) Date of publication of application: 02.12.2009
(73) Proprietor: VIA Technologies, Inc., Taipei Hsien (TW)
(72) Inventor: Ho, Kwun-Yao, Hsin-Tien City Taipei Hsien (TW); Chang, Wen-Yuan, Hsin-Tien City Taipei Hsien (TW); Kung, Chen-Yueh, Hsin-Tien City Taipei Hsien (TW); Lin, Ming-Jen, Hsin-Tien City Taipei Hsien (TW)
(74) Representative: Becker Kurig Straus

(56) References cited:
- US-A- 4 130 723
- US-A- 6 093 038
- US-A1- 2002 157 865
- US-A1- 2003 112 617
- US-A1- 2006 244 124
- US-A1- 2006 258 179
- US-B1- 6 769 920

## Description

### BACKGROUND OF THE INVENTION

### 1. Field of the Invention

The present invention generally relates to an electronic apparatus and, in particular, to an electronic apparatus using a flexible printed circuit (FPC).

### 2. Description of Related Art

Computers such as personal computers (PC), notebook computers, tablet computers, etc. have been very popular nowadays. People access the internet to communicate with the world through computers, such that the transportation of information becomes faster. Computers change people's life styles and bring much convenience in daily lives.

A conventional PC includes a mother board, a plurality of system components, and a plurality of input/output (I/O) components. The system components and the I/O components are disposed on the mother board. The system components include a central processing unit (CPU), a chipset including north bridge and south bridge chips, a basic input/output system (BIOS), a memory module, a clock generator, a power management, etc.
The I/O components include a video jack, an audio jack, universal system bus (USB) jacks, a keyboard jack, a mouse jack, etc. In some advanced PC, the mother board even includes I/O components such as wireless communication module, global positioning system (GPS) module, etc.

Generally speaking, the needs of the I/O functions of a mother board are various among different customers. For example, the keyboard jack and the mouse jack, such as personal system/2 (PS/2) jacks, may be necessary for some customers. However, for other customers, more USB jacks are needed to replace the keyboard jack and the mouse jack, such that the keyboard jack and the mouse jack are not needed. Since the system components and the I/O components are disposed on a single mother board, the designs of the mother board must be changed just due to the needs of the I/O components are different-In this way, the cost of the PC is increased, and the time to market is too long. If the designs of the mother board are not changed with different requirements of customers, some I/O components may be redundant and not used by user, which causes a waste of I/O components. In addition, the layout of a single mother board has less flexibility for matching various appearances of PCs. US 2006/0258179 describes a known printed circuit board, connector and electronic device comprising a main board and a sub PCB connected by a flexible printed circuit board. US 2003/112617 describes known wiring boards. US 4,130,723 describes a known printed circuit with laterally displaced ground and signal conductor tracks. US 6,093,038 describes a known movable connector board for computer. US 2002/0157865 describes known flexible flat circuitry with improved shieiding..

### SUMMARY OF THE INVENTION

Accordingly, the present invention is directed to an electronic apparatus which has both a lower cost and more design flexibility.

According to the present invention there is provided an electronic apparatus as claimed in claim 1.

In the electronic apparatus according to the embodiment of the present invention, the I/O board is connected to the main board through the FPC. When the requirements of I/O functions from different customers are different, only the designs of the I/O board are needed to be different, but the main board is the same and adapted to different requirements. In this way, the cost of the electronic apparatus is reduced.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a schematic structural view of an electronic apparatus according to an embodiment of the present invention.

FIG. 2 is a schematic local cross-sectional view of the FPC in FIG. 1.

FIG. 3A is a simplified local cross-sectional view of the FPC in FIG. 1.

FIG. 3B is schematic local top view of the second conductive layer of the FPC in FIG. 2.

FIG. 4 is a schematic structural view of an electronic apparatus according to another embodiment of the present invention.

### DESCRIPTION OF THE EMBODIMENTS

Reference will now be made in detail to the present embodiments of the invention, examples of which are illustrated in the accompanying drawings. Wherever possible, the same reference numbers are used in the drawings and the description to refer to the same or like parts.

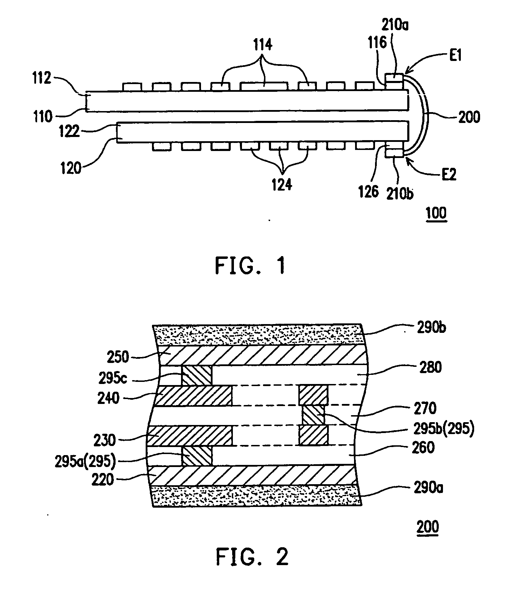

FIG. 1 is a schematic structural view of an electronic apparatus according to an embodiment of the present invention. Referring to FIG. 1, the electronic apparatus 100 of the present embodiment is, for example, a personal computer (PC), a notebook computer, a tablet computer, a personal digital assistant (PDA), a phone PC, or other appropriate electronic apparatus. The electronic apparatus 100 includes a main board 110. The main board 110 includes a first carrier 112 and a plurality of system components 114. In the present embodiment, the first carrier 112 is, for example, a circuit substrate. The system components 114 are disposed on the first carrier 112, and include a central processing unit (CPU), a north bridge unit, a south bridge unit, a basic input/output system (BIOS), a memory module, a clock generator, a graphic unit, at least one power management. Additionally, the system components 114 may further include a plurality of passive components, other IC components or other appropriate system components.

In the present embodiment, the CPU, the north bridge unit, the south bridge unit, the BIOS, the memory module, the clock generator, the graphic unit, and the power management are individual components. However, in other embodiments (not shown), at least two of the CPU, the north bridge unit, the south bridge unit, the BIOS, the memory module, the clock generator, the graphic unit, and the power management may compose a single combination chip. For example, (i) the single combination chip is composed of the north bridge unit and the south bridge unit and has multiple functions; (ii) the single combination chip is composed of the north bridge unit and the CPU and has multiple functions, and the south bridge unit is a individual chip; (iii) the single combination chip is composed of the north bridge unit, the south bridge unit, and the CPU and has multiple functions; (iv) the single combination chip is composed of the north bridge unit, the south bridge unit, and the power management and has multiple functions; (v) the single combination chip is composed of the north bridge unit, the south bridge unit, and the clock generator and has multiple functions; (vi) the single combination chip is composed of the north bridge unit, the south bridge unit, and the graphic unit and has multiple functions; (vii) the single combination chip is composed of the north bridge unit, the south bridge unit, the graphic unit, and the CPU and has multiple functions.

The electronic apparatus 100 further includes an input/output (I/O) board 120. The I/O board 120 includes a second carrier 122 and a plurality of I/O components 124. The second carrier 122 is, for example, a circuit substrate. The I/O components 124 are disposed on the second carrier 122. The I/O components 124 include a video connector. In the present embodiment, the I/O components 124 may further include at least one of an audio connector, at least one universal system bus (USB) connector, a keyboard connector, a mouse connector, a plurality of passive components, wireless communication modules, a global positioning system (GPS) module, or other appropriate I/O components, in which the wireless communication modules are, for example, a Wi-Fi module, a blue tooth module, a radio frequency (RF) module, etc. More particularly, the video connector, the audio connector, the USB connector, the keyboard connector, and the mouse connector may be a video jack, an audio jack, a USB jack, a keyboard jack, and a mouse jack, respectively.

The electronic apparatus 100 further includes a flexible printed circuit (FPC) 200. The FPC 200 connects the first carrier 112 and the second carrier 122. In the present embodiment, the main board 112 further includes a first connector 116 disposed on the first carrier 112, and the I/O board 122 further includes a second connector 126 disposed on the second carrier 122. Moreover, in the present embodiment, the FPC 200 includes a third connector 210a at a first end E1 of the FPC 200 and a fourth connector 210b at a second end E2 of the FPC 200 opposite to the first end E1. The third connector 210a is connected to the first connector 116, and the fourth connector 210b is connected to the second connector 126. In this way, the main board 110 is electronically connected with the I/O board 120 through the FPC 200. Therefore, a signal from the system component 114 of the main board 110 will pass through the first connector 116 of the main board 110, the third connector 210a of the FPC 200, the FPC 200, the fourth connector 210b of the FPC 200 and the second connector 126 of the I/O board 120, and then be transmitted to the I/O board 122. On the other hand, a signal from the I/O board will pass through the second connector 126 of the I/O board 120, the fourth connector 210b of the FPC 200, the FPC 200, the third connector 210a of the FPC 200, the first connector 116 of the main board 110, and then be transmitted to the system component 114 of the main board 110.

In the electronic apparatus 100 of the present embodiment, the main board 110 and the I/O board 120 are individual boards and connected with each other through the FPC 200. When the requirements of the I/O functions from different customers are different, only a kind of I/O board 120 should be replaced by other kinds of I/O boards 120, but the main board 110 is the same and adapted to various requirements. Different kinds of the I/O boards 120 may have different I/O functions. For example, some customers don't need wireless communication modules for their electronic apparatus, such that wireless communication modules are not necessary to equip on the I/O board 120. Therefore, the size of the I/O boards 120 can be reduced and the cost can be down, too. In summary, the I/O components 124 equipped on the I/O board 120 can be chosen by customers' needs or requirements. The I/O board 120 can be customized. In this way, the cost of the electronic apparatus 100 is reduced because the main board 110 does not need to be replaced when the requirement of the I/O functions is changed and because the main board 110 does not need to be debugged every time the requirement of the I/O functions is changed. Additionally, the time to market of the electronic apparatus 100 is shortened because the main board 110 does not need to be redesigned and redebugged every time the requirement of the I/O function is changed. Moreover, since the FPC 200 is flexible, the layout of the main board 110 and the I/O board 120 has more flexibility for matching various appearances of the electronic apparatus 100. Furthermore, the horizontal layout area of the electronic apparatus 100 can be reduced because the main board 110 can overlap with the I/O board 120 through the FPC 200 in the vertical direction.

FIG. 2 is a schematic local cross-sectional view of the FPC in FIG. 1. Referring to FIG. 2, in the present embodiment, the FPC 200 includes a first conductive layer 220, a first patterned conductive layer 230, a second patterned conductive layer 240, and a second conductive layer 250. The material of the first conductive layer 220, a first patterned conductive layer 230, a second patterned conductive layer 240, and a second conductive layer 250 is, for example, metal or appropriate conductive non-metal. The first patterned conductive layer 230 is disposed above the first conductive layer 220. The second patterned conductive layer 240 is disposed above the first patterned conductive layer 230. The second conductive layer 250 is disposed above the second patterned conductive layer 240. In particular, the FPC 200 further includes a first insulating layer 260, a second insulating layer 270, and a third insulating layer 280.

The first insulating layer 260 is disposed between the first conductive layer 220 and the first patterned conductive layer 230. The second insulating layer 270 is disposed between the first patterned conductive layer 230 and the second patterned conductive layer 240. The third insulating layer 280 is disposed between the second patterned conductive layer 240 and the second conductive layer 250.

Additionally, in the present embodiment, the FPC 200 further includes two preservation layers 290a, 290b disposed on the first conductive layer 220 and the second conductive layer 250, respectively. The FPC 200 may further include a plurality of conducting vias 295, and each conducting via 295 electrically connects two conductive layers. For example, the conducting via 295a electrically connects the first conductive layer 220 and the first patterned conductive layer 230, the conducting via 295b electrically connects the first patterned conductive layer 230 and the second patterned conductive layer 240, and the conducting via 295c electrically connects the second patterned conductive layer 240 and the second conductive layer 250.

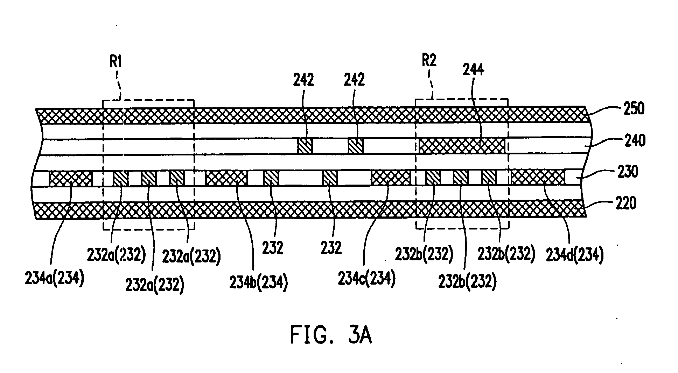

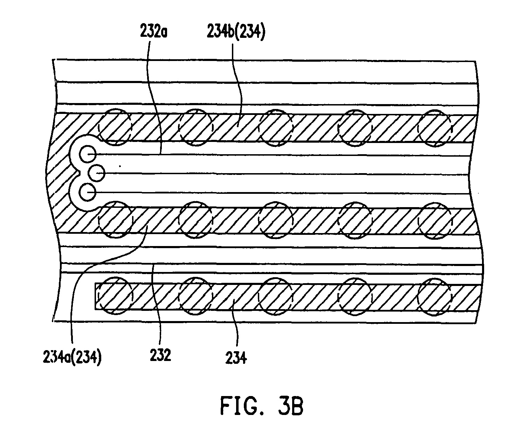

FIG. 3A is a simplified local cross-sectional view of the FPC in FIG. 1, and FIG. 3B is schematic local top view of the second conductive layer of the FPC in FIG. 2. Referring to FIGs. 3A and 3B, in the present embodiment, the first patterned conductive layer 230 includes a plurality of signal traces 232, and the second patterned layer 240 includes a plurality of signal traces 242. The signal traces 232 do not overlap the signal traces 242, which reduces the electromagnetic interference between the signal traces 232 and the signal traces 242. Additionally, in the present embodiment, the first conductive layer 220 and the second conductive layer 250 are adapted to be electrically connected to ground, which provides impedance control, ground guarding control, and electromagnetic interference shielding, such that the signal traces 232 and the signal traces 242 may carry differential pair signals and high speed signals.

In the present embodiment, the FPC 200 has a universal system bus (USB) region R1. The first patterned conductive layer 230 includes a plurality of first signal traces 232a and two ground guarding traces 234, such as ground guarding traces 234a and 234b. The first signal traces 232a are disposed within the USB region R1 and adapted to carry USB signals. The two ground guarding traces 234a and 234b are disposed at two opposite sides of the USB region R1, respectively. The second patterned conductive layer 240 has no metal trace located within the USB region R1 or overlapping the first signal traces 232a. The ground guarding traces 234 are adapted to be electrically connected to ground, which makes the first signal traces 232a carry high speed signals, differential pair signals, analogy signals, and well controlled signals, and the signal quality be protected.

In the present embodiment, the FPC 200 has a video signal region R2. The first patterned conductive layer 230 includes a plurality of second signal traces 232b and two ground guarding traces 234c and 234d. The second signal traces 232b are disposed within the video signal region R2 and adapted to carry video signals, such as RGB signals or other types of video signals. The two ground guarding traces 234c and 234d are disposed at two opposite sides of the video signal region R2, respectively. In the present embodiment, the second patterned conductive layer 240 includes a ground guarding trace 244. The orthogonal projections of the second signal traces 232b on the second patterned conductive layer 240 are located within the ground guarding trace 244. The ground guarding traces 234c, 234d and the ground guarding trace 244 are adapted to be electrically connected to ground, such that the second signal traces 232b can carry high speed signals and well controlled signals, and the signal quality is protected.

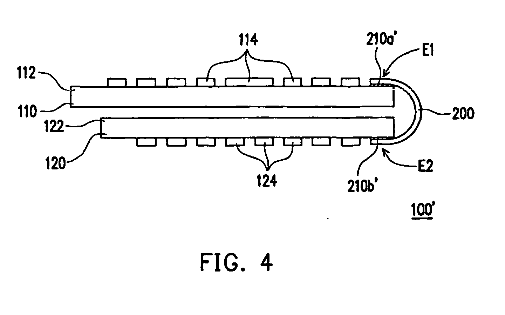

FIG. 4 is a schematic structural view of an electronic apparatus according to another embodiment of the present invention. Referring to FIG. 4, the electronic apparatus 100' of the present embodiment is similar to the above electronic apparatus 100 shown in FIG. 1, and the differences therebetween are as follows. The electronic apparatus 100' includes a plurality of first finger pads 210a' and a plurality of second finger pads 210b'. The first finger pads 210a' connects the first carrier 112 and the first end E1 of the FPC 200, and the second finger pads 210b' connects the second carrier 122 and the second end E2 of the FPC 200, such that the main board 110 is electrically connected with the I/O board 120 through the FPC 200.

To sum up, in the electronic apparatus according to the embodiments of the present invention, the main board and the I/O board are individual boards and connected with each other through the FPC. When the requirements of the I/O functions from different customers are different, only a kind of I/O board should be replaced by other kinds of I/O boards, but the main board is the same and adapted to various requirements. Different kinds of the I/O boards may have different I/O functions. In this way, the cost of the electronic apparatus is reduced because the main board does not need to be replaced when the requirement of the I/O functions is changed and because the main board does not need to be debugged every time the requirement of the I/O functions is changed.

Additionally, the time to market of the electronic apparatus is shortened because the main board does not need to be redesigned and redebugged every time the requirement of the I/O function is changed. Moreover, since the FPC is flexible, the layout of the main board and the I/O board has more flexibility for matching various appearances of the electronic apparatus. Furthermore, the horizontal layout area of the electronic apparatus can be reduced because the main board can overlay with the I/O board through the FPC in the vertical direction.

Moreover, the signals transmitted in the signal traces are protected by the ground guarding traces, the first conductive layer electrically connected to ground, and the second conductive layer electrically connected to ground, which makes the signal traces carry high speed signals, differential pair signals, analog signals, and well controlled signals, and the signal quality be protected.

## Claims

1. An electronic apparatus (100) comprising:
a main board (110) comprising:
a first carrier (112);
a plurality of system components (114) comprising:
a central processing unit (CPU) disposed on the first carrier (112);
a north bridge unit disposed on the first carrier (112);
a south bridge unit disposed on the first carrier (112);
a basic input/output system (BIOS) disposed on the first carrier (112);
a memory module disposed on the first carrier (112);
a clock generator disposed on the first carrier (112);
a graphic unit disposed on the first carrier (112); and
at least one power management disposed on the first carrier (112); and
an input/output (I/O) board (120) comprising:
a second carrier (122); and
a wireless communication module disposed on the second carrier (122);
a video connector disposed on the second carrier (122); and
a flexible printed circuit (FPC) (200) connecting the first carrier (112) and the second carrier (122), the FPC (200) comprises:
a first conductive layer (220) adapted to be electrically connected to ground;
a first patterned conductive layer (230) disposed above the first conductive layer (220);
a second patterned conductive layer (240) disposed above the first patterned conductive layer (220);
a second conductive layer (250) disposed above the second patterned conductive layer (240) and adapted to be electrically connected to ground;
a first insulating layer (260) disposed between the first conductive layer (220) and the first patterned conductive layer (230);
a second insulating layer (270) disposed between the first patterned conductive layer (230) and the second patterned conductive layer (240); and
a third insulating layer (280) disposed between the second patterned conductive layer (240) and the second conductive layer (250),
wherein the FPC (200) has a universal system bus (USB) region (R1), and the first patterned conductive layer (230) comprises:
a plurality of first signal traces (232a) disposed within the USB region (R1); and
two first ground guarding traces (234a, 234b) respectively disposed at two opposite sides of the USB region (R1),
wherein the second patterned conductive layer (240) has no metal trace located within the USB region (R1) or overlapping the first signal traces (232a),
wherein the FPC (200) has a video signal region (R2), and the first patterned conductive layer (230) comprises:
a plurality of second signal traces (232b) disposed within the video signal region (R2); and
two second ground guarding traces (234c, 234d) respectively disposed at two opposite sides of the video signal region (R2),
wherein the second patterned conductive layer (240) comprises a second ground guarding trace (244), and orthogonal projections of the second signal traces (232b) on the second patterned conductive layer (240) are located within the second ground guarding trace (244).

2. The electronic apparatus (100) according to claim 1, wherein the first patterned conductive layer (230) comprises a plurality of first signal traces (232), the second patterned conductive layer (240) comprises a plurality of second signal traces (242), and the first signal traces (232) do not overlap the second signal traces (242).

3. The electronic apparatus (100) according to claim 1, wherein the main board (110) further comprises a first connector (116) disposed on the first carrier (112), the I/O board (122) further comprises a second connector (126) disposed on the second carrier (122), the FPC (200) comprises a third connector (210a) at one end (E1) of the FPC (200) and a fourth connector (210b) at another end (E2) of the FPC (200) opposite to the end (E1), the third connector (210a) is connected to the first connector (116), and the fourth connector (21 0b) is connected to the second connector (126).

4. The electronic apparatus (100) according to claim 3, wherein a signal from the main board (110) passes through the first connector (116) of the main board (110), the third connector (210a) of the FPC (200), the FPC (200), the fourth connector (21 0b) of the FPC (200) and the second connector (126) of the I/O board (120), and is then transmitted to the I/O board (122).

5. The electronic apparatus (100) according to claim 3, wherein a signal from the I/O board (120) passes through the second connector (126) of the I/O board (120), the fourth connector (210b) of the FPC (200), the FPC (200), the third connector (210a) of the FPC (200), the first connector (116) of the main board (110), and is then transmitted to the main board (110).

6. The electronic apparatus (100) according to claim 1, further comprising:
a plurality of first finger pads (210a') connecting the first carrier (112) and one end (E1) of the FPC (200); and
a plurality of second finger pads (210b') connecting the second carrier (122) and another end (E2) of the FPC (200) opposite to the end (E1) of the FPC (200).

7. The electronic apparatus (100) according to claim 1, wherein at least two of the CPU, the north bridge unit, the south bridge unit, the BIOS, the memory module, the clock generator, the graphic unit, and the power management compose a single combination chip

8. The electronic apparatus (100) according to claim 1, wherein the I/O board (120) - further comprises global positioning system (GPS) module disposed on the second carrier.

9. The electronic apparatus (100) according to claim 1, wherein the I/O board (120) further comprises a USB connector disposed on the second carrier (122).

10. The electronic apparatus (100) according to claim 1 further comprising a plurality of passive components disposed on the first carrier (112) or/and on the second carrier (122).

## Patentansprüche

1. Elektronische Vorrichtung (100), umfassend
eine Hauptplatine (110), umfassend
einen ersten Träger (112);
eine Mehrzahl von Systembestandteilen (114), umfassend
einen Hauptprozessor (CPU), der auf dem ersten Träger (112) angeordnet ist;
eine Northbridge-Einheit, die auf dem ersten Träger (112) angeordnet ist;
eine Southbridge-Einheit, die auf dem ersten Träger (112) angeordnet ist;
ein Basis-Eingabe-/Ausgabesystem (BIOS), das auf dem ersten Träger (112) angeordnet ist;
ein Speichermodul, das auf dem ersten Träger (112) angeordnet ist;
einen Taktgenerator, der auf dem ersten Träger (112) angeordnet ist;
eine Graphik-Einheit, die auf dem ersten Träger (112) angeordnet ist; und mindestens eine Energieverwaltung, die auf dem ersten Träger (112) angeordnet ist; und
eine Eingangs-/Ausgangsplatine (I/O) (120), umfassend
einen zweiten Träger (122); und
ein Drahtlos-Kommunikationsmodul, das auf dem zweiten Träger (122) angeordnet ist;
einen Videoanschluss, der auf dem zweiten Träger (122) angeordnet ist; und
eine flexible gedruckte Schaltung (FPC) (200), die den ersten Träger (112) und den zweiten Träger (122) verbindet, wobei die FPC (200) umfasst
eine erste Leitungsschicht (220), die so angepasst ist, dass sie elektrisch mit Masse verbunden ist;
eine erste strukturierte Leitungsschicht (230), die oberhalb der ersten Leitungsschicht (220) angeordnet ist;
eine zweite strukturierte Leitungsschicht (240), die oberhalb der ersten strukturierten Leitungsschicht (220) angeordnet ist;
eine zweite Leitungsschicht (250), die oberhalb der zweiten strukturierten Leitungsschicht (240) angeordnet ist und so angepasst ist, dass sie elektrisch mit Masse verbunden ist;
eine erste Isolierschicht (260), die zwischen der ersten Leitungsschicht (220) und der ersten strukturierten Leitungsschicht (230) angeordnet ist;
eine zweite Isolierschicht (270), die zwischen der ersten strukturierten Leitungsschicht (230) und der zweiten strukturierten Leitungsschicht (240) angeordnet ist; und
eine dritte Isolierschicht (280), die zwischen der zweiten strukturierten Leitungsschicht (240) und der zweiten Leitungsschicht (250) angeordnet ist,
wobei die FPC (200) einen universellen Systembus (USB)-Bereich (R1) aufweist, und die erste strukturierte Leitungsschicht (230) umfasst
eine Vielzahl von ersten Signalleiterbahnen (232a), die innerhalb des USB-Bereichs (R1) angeordnet sind, und
zwei erste Erdungsschutzleiterbahnen (234a, 234b), die jeweils auf zwei gegenüberliegenden Seiten des USB-Bereichs (R1) angeordnet sind,
wobei die zweite strukturierte Leitungsschicht (240) keine Metallleiterbahn hat, die sich innerhalb des USB-Bereichs (R1) befindet oder die ersten Signalleiterbahnen (232a) überlappt,
wobei die FPC (200) einen Videosignal-Bereich (R2) aufweist, und die erste strukturierte Leitungsschicht (230) umfasst
eine Vielzahl von zweiten Signalleiterbahnen (232b), die innerhalb des Videosignal-Bereichs (R2) angeordnet sind; und
zwei zweite Erdungsschutzleiterbahnen (234c, 234d), die jeweils auf zwei sich gegenüberliegenden Seiten des Videosignal-Bereichs (R2) angeordnet sind,
wobei die zweite strukturierte Leitungsschicht (240) eine zweite Erdungsschutzleiterbahn (244) umfasst und sich senkrechte Projektionen der zweiten Signalleiterbahnen (232b) auf der zweiten strukturierten Leitungsschicht (240) innerhalb der zweiten Erdungsschutzleiterbahn (244) befinden.

2. Elektronische Vorrichtung (100) gemäß Anspruch 1, wobei die erste strukturierte Leitungsschicht (230) eine Vielzahl von ersten Signalleiterbahnen (232) umfasst, die zweite strukturierte Leitungsschicht (240) eine Vielzahl von zweiten Signalleiterbahnen (242) umfasst, und die ersten Signalleiterbahnen (232) die zweiten Signalleiterbahnen (242) nicht überlappen.

3. Elektronische Vorrichtung (100) gemäß Anspruch 1, wobei die Hauptplatine (110) außerdem einen ersten Anschluss (116) umfasst, der auf dem ersten Träger (112) angeordnet ist, die I-/O-Platine (122) außerdem einen zweiten Anschluss (126) umfasst, der auf dem zweiten Träger (122) angeordnet ist, die FPC (200) einen dritten Anschluss (210a) an einem Ende (E1) der FPC (200) und einen vierten Anschluss (210b) an einem anderen Ende (E2) der FPC (200) gegenüber dem Ende (E1) umfasst, wobei der dritte Anschluss (210a) mit dem ersten Anschluss (116) verbunden ist und der vierte Anschluss (210b) mit dem zweiten Anschluss (126) verbunden ist.

4. Elektronische Vorrichtung (100) gemäß Anspruch 3, wobei ein Signal von der Hauptplatine (110) durch den ersten Anschluss (116) der Hauptplatine (110), den dritten Anschluss (210a) der FPC (200), die FPC (200), den vierten Anschluss (210b) der FPC (200) und den zweiten Anschluss (126) der I-/O-Platine (120) läuft, und dann an die I-/O-Platine (122) übermittelt wird.

5. Elektronische Vorrichtung (100) gemäß Anspruch 3, wobei ein Signal von der I-/O-Platine (120) durch den zweiten Anschluss (126) der I-/O-Platine (120), den vierten Anschluss (210b) der FPC (200), die FPC (200), den dritten Anschluss (210a) der FPC (200) und den ersten Anschluss (116) der Hauptplatine (110) läuft, und dann an die Hauptplatine (110) übermittelt wird.

6. Elektronische Vorrichtung (100) gemäß Anspruch 1, außerdem umfassend eine Vielzahl von ersten Finger-Kontaktstellen (210a'), die den ersten Träger (112) und ein Ende (E1) der FPC (200) verbinden; und
eine Vielzahl von zweiten Finger-Kontaktstellen (210b'), die den zweiten Träger (122) und ein anderes Ende (E2) der FPC (200) gegenüber dem Ende (E1) der FPC (200) verbinden.

7. Elektronische Vorrichtung (100) gemäß Anspruch 1, wobei mindestens zwei aus der CPU, der Northbridge-Einheit, der Southbridge-Einheit, dem BIOS, dem Speichermodul, dem Taktgenerator, der Graphikeinheit und der Energieverwaltung einen einzelnen Kombinationschip zusammensetzen.

8. Elektronische Vorrichtung (100) gemäß Anspruch 1, wobei die I-/O-Platine (120) außerdem ein globales Positionierungssystem (GPS)-Modul umfasst, das auf dem zweiten Träger angeordnet ist.

9. Elektronische Vorrichtung (100) gemäß Anspruch 1, wobei die I-/O-Platine (120) außerdem einen USB-Anschluss umfasst, der auf dem zweiten Träger (122) angeordnet ist.

10. Elektronische Vorrichtung (100) gemäß Anspruch 1, die außerdem eine Vielzahl passiver Bauteile umfasst, die auf dem ersten Träger (112) oder/und auf dem zweiten Träger (122) angeordnet sind.

## Revendications

1. Appareil électronique (100) comprenant :
une carte principale (110) comprenant :
un premier support (112) ;
une pluralité de composants de système (114) comprenant :
une unité centrale (CPU) disposée sur le premier support (112) ;
une unité de pont nord disposée sur le premier support (112) ;
une unité de pont sud disposée sur le premier support (112) ;
un système d'entrée/sortie de base (BIOS) disposé sur le premier support (112) ;
un module de mémoire disposé sur le premier support (112) ;
un générateur d'horloge disposé sur le premier support (112) ;
une unité graphique disposée sur le premier support (112) ; et
au moins une gestion d'alimentation électrique disposée sur le premier support (112) ; et
une carte d'entrée/sortie (E/S) (120) comprenant :
un deuxième support (122) ; et
un module de communication sans fil disposé sur le deuxième support (122) ;
un connecteur vidéo disposé sur le deuxième support (122) ; et
un circuit imprimé flexible (FPC) (200) reliant le premier support (112) et le deuxième support (122), le FPC (200) comprenant :
une première couche conductrice (220) apte à être électriquement reliée à la masse ;
une première couche conductrice en motif (230) disposée au-dessus de la première couche conductrice (220) ;
une deuxième couche conductrice en motif (240) disposée au-dessus de la première couche conductrice en motif (230) ;
une deuxième couche conductrice (250) disposée au-dessus de la deuxième couche conductrice en motif (240) et apte à être électriquement reliée à la masse ; ;
une première couche isolante (260) disposée entre la première couche conductrice (220) et la première couche conductrice en motif (230) ;
une deuxième couche isolante (270) disposée entre la première couche conductrice en motif (230) et la deuxième couche conductrice en motif (240) ; et
une troisième couche isolante (280) disposée entre la deuxième couche conductrice en motif (240) et la deuxième couche conductrice (250),
dans lequel le FPC (200) comporte une région de bus de système universel (USB) (R1), et la première couche conductrice en motif (230) comprend :
une pluralité de premières pistes de signal (232a) disposées à l'intérieur de la région USB (R1) ; et
deux premières pistes de protection de masse (234a, 234b) disposées respectivement sur deux côtés opposés de la région USB (R1),
dans lequel la deuxième couche conductrice en motif (240) n'a pas de piste métallique située à l'intérieur de la région USB (R1) ou chevauchant les premières pistes de signal (232a),
dans lequel le FPC (200) comporte une région de signal vidéo (R2), et la première couche conductrice en motif (230) comprend :
une pluralité de deuxièmes pistes de signal (232b) disposées à l'intérieur de la région de signal vidéo (R2) ; et
deux deuxièmes pistes de protection de masse (234c, 234d) disposées respectivement sur deux côtés opposés de la région de signal vidéo (R2),
dans lequel la deuxième couche conductrice en motif (240) comprend une deuxième piste de protection de masse (244), et des saillies orthogonales des deuxièmes pistes de signal (232b) sur la deuxième couche conductrice en motif (240) sont situées à l'intérieur de la deuxième piste de protection de masse (244).

2. Appareil électronique (100) selon la revendication 1, dans lequel la première couche conductrice en motif (230) comprend une pluralité de premières pistes de signal (232), la deuxième couche conductrice en motif (240) comprend une pluralité de deuxièmes pistes de signal (242), et les premières pistes de signal (232) ne chevauchent pas les deuxièmes pistes de signal (242).

3. Appareil électronique (100) selon la revendication 1, dans lequel la carte principale (110) comprend en outre un premier connecteur (116) disposé sur le premier support (112), la carte d'entrée/sortie (122) comprend en outre un deuxième connecteur (126) disposé sur le deuxième support (122), le FPC (200) comprend un troisième connecteur (210a) à une extrémité (E1) du FPC (200) et un quatrième connecteur (210b) à une autre extrémité (E2) du FPC (200) à l'opposé de l'extrémité (E1), le troisième connecteur (210a) est relié au premier connecteur (116), et le quatrième connecteur (210b) est relié au deuxième connecteur (126).

4. Appareil électronique (100) selon la revendication 3, dans lequel un signal provenant de la carte principale (110) passe à travers le premier connecteur (116) de la carte principale (110), le troisième connecteur (210a) du FPC (200), le FPC (200), le quatrième connecteur (210b) du FPC (200) et le deuxième connecteur (126) de la carte d'entrée/sortie (120), puis est transmis à la carte d'entrée/sortie (120).

5. Appareil électronique (100) selon la revendication 3, dans lequel un signal provenant de la carte d'entrée/sortie (120) passe à travers le deuxième connecteur (126) de la carte d'entrée/sortie (120), le quatrième connecteur (210b) du FPC (200), le FPC (200), le troisième connecteur (210a) du FPC (200), le premier connecteur (116) de la carte principale (110), puis est transmis à la carte principale (110).

6. Appareil électronique (100) selon la revendication 1, comprenant en outre :
une pluralité de premiers plots (210a') reliant le premier support (112) et une extrémité (E1) du FPC (200) ; et
une pluralité de deuxièmes plots (210b') reliant le deuxième support (122) et une autre extrémité (E2) du FPC (200) à l'opposé de l'extrémité (E1) du FPC (200).

7. Appareil électronique (100) selon la revendication 1, dans lequel au moins deux de l'unité centrale, l'unité de pont nord, l'unité de pont sud, le BIOS, le module de mémoire, le générateur d'horloge, l'unité graphique et la gestion d'alimentation électrique se composent d'une seule puce de combinaison.

8. Appareil électronique (100) selon la revendication 1, dans lequel la carte d'entrée/sortie (120) comprend en outre un module de système de positionnement global (GPS) disposé sur le deuxième support.

9. Appareil électronique (100) selon la revendication 1, dans lequel la carte d'entrée/sortie (120) comprend en outre un connecteur USB disposé sur le deuxième support (122).

10. Appareil électronique (100) selon la revendication 1, comprenant en outre une pluralité de composants passifs disposés sur le premier support (112) et/ou sur le deuxième support (122).
